# FASCICULE DE BREVET EUROPEEN

(11) **EP 0 316 207 B1**
(45) Date de publication et mention de la délivrance du brevet: **13.08.1997**
(21) Numéro de dépôt: 88402563.6
(22) Date de dépôt: 11.10.1988
(51) Int. Cl.: G03F 7/00, G03F 7/20, G02B 5/32, G03H 1/02

(54) **Procédé pour fabriquer un miroir holographique**
Verfahren zur Herstellung eines holographischen Spiegels
Process for the fabrication of a holographic mirror

(30) Priorité: 12.10.1987 DE 3734438
(43) Date de publication de la demande: 17.05.1989
(73) Titulaire: SAINT-GOBAIN VITRAGE, 92400 Courbevoie (FR); VEGLA Vereinigte Glaswerke GmbH, D-52066 Aachen (DE); Volkswagen Aktiengesellschaft, 38436 Wolfsburg (DE)
(72) Inventeur: Windeln, Wilbert, D-5138 Heinsberg (DE); Beeck, Manfred-Andreas, D-3170 Gifhorn (DE); Bartonitscheck, Norbert, D-5190 Stolberg (DE)
(74) Mandataire: Renous Chan, Véronique

(56) Documents cités:
- GB-A- 2 069 715
- GB-A- 2 071 866
- GB-A- 2 159 979
- GB-A- 2 215 484
- US-A- 3 551 018

## Description

La présente invention concerne un procédé de réalisation d'un miroir holographique obtenu en exposant une couche photosensible à des rayonnements laser qui interfèrent et à l'aide desquels on obtient, à l'intérieur même de la couche photosensible, parallèlement à sa surface, des plans d'égale différence de phase espacés d'une distance prédéterminée par la longueur d'onde de la lumière destinée à être réfléchie par l'hologramme.

Les couches photosensibles ainsi exposées sont ensuite développées d'une manière connue. A titre de couches photosensibles, des couches de gélatine bichromatée se sont avérées particulièrement satisfaisantes pour la confection de tels miroirs holographiques.

Selon le procédé connu, pour confectionner des miroirs holographiques, on place la couche photosensible sur un substrat transparent plan, parallèlement à un miroir, et on l'expose sur toute sa surface à un faisceau laser étendu dans ses deux dimensions pour lui donner la section voulue. La lumière laser traverse une première fois la couche photosensible et le substrat constituant ainsi l'onde de référence, elle est réfléchie par la surface du miroir, traverse à nouveau la pellicule en tant qu'onde objet et forme dans la couche photosensible les plans d'interférence souhaités.

Ce procédé connu présente divers inconvénients lorsqu'il s'agit de confectionner des miroirs holographiques qui soient homogènes. Ainsi, par exemple dans le cas particulier d'hologrammes étendus, il est extraordinairement difficile de maintenir constante avec la précision exigée la distance entre la couche photosensible et la surface du miroir pendant la durée du temps d'exposition. Cette distance doit en effet être maintenue constante sur toute la surface avec une précision de l'ordre de fractions de la longueur d'onde de la lumière, si l'on veut confectionner un hologramme possédant des propriétés de réflexion uniformes, car d'infimes variations de distance pendant le temps d'exposition conduisent déjà à une effacement ou un affaiblissement de la figure d'interférence formée. De plus, la grandeur maximum possible de l'hologramme ainsi obtenu est limitée par le fait que l'éclairement homogène nécessaire de l'ensemble de la surface est difficile à réaliser. On peut certes procéder à l'illumination segment par segment en exposant des éléments de surface individuels successivement, mais dans ce cas il est inévitable que les joints deviennent visibles et gênants.

C'est ainsi que le document GB-A-2 071 866 décrit une technique où le faisceau laser balaye une suite de lignes parallèles qui sont séparées l'une de l'autre par une certaine distance verticale, le faisceau laser sautant abruptement au bout de chaque ligne dans une direction verticale jusqu'au début de la ligne horizontale suivante. Ces lignes horizontales successives sont donc séparées et les joints deviennent visibles et gênants.

Certains domaines d'utilisation exigent des miroirs holographiques homogènes relativement étendus. C'est le cas, par exemple, lorsque le pare-brise d'un véhicule automobile doit être pourvu, sur la totalité de sa surface ou sur une partie de celle-ci, d'un tel miroir holographique, comme décrit dans le document DE-OS 31 36 946. Dans ce cas, l'hologramme constitue un miroir holographique pour lumière blanche et doit réfléchir le rayonnement solaire arrivant du haut, tandis que, dans la direction horizontale, les rayons lumineux doivent le traverser sans entrave. Des miroirs holographiques relativement étendus sont également nécessaires lorsqu'un miroir holographique destiné à rendre visible des signaux ou des informations optiques dans le champ de vision du conducteur, doit, par exemple, être installé dans le champ de vision d'un pare-brise. L'utilisation d'un miroir holographique à cet effet est décrite, par exemple, dans le document EP-216 692.

L'invention a pour but de développer le procédé précité de confection de miroirs holographiques d'une manière telle que la confection de miroirs holographiques étendus soit simplifiée et améliorée.

Suivant l'invention, ce but est atteint par un procédé de réalisation d'un miroir holographique étendu qui est obtenu en exposant une couche photosensible à des rayonnements laser qui interfèrent et à l'aide desquels on obtient, à l'intérieur même de la couche photosensible, parallèlement à sa surface, des plans d'égale différence de phase espacés d'une distance prédéterminée par la longueur d'onde de la lumière destinée à être réfléchie par l'hologramme dans lequel la couche photosensible est éclairée selon des lignes ou des bandes par au moins un faisceau laser sous une incidence donnée dans une première direction, et dans lequel, dans une deuxième direction parallèlement à la surface de la couche photosensible, on crée un mouvement relatif entre la couche photosensible et le faisceau laser avec une vitesse telle qu'elle garantisse un éclairage suffisant de ladite couche, ainsi que dans lequel le mouvement relatif entre la couche photosensible et le faisceau laser est un mouvement continu.

Suivant une première forme d'exécution du nouveau procédé, on utilise à titre de faisceau laser, un pinceau laser statique divergent, à section essentiellement unidimensionnelle, qui forme sur la couche photosensible une bande lumineuse s'étendant dans la première direction.

Dans une deuxième forme d'exécution, on utilise, à titre de faisceau laser, un faisceau laser parallèle, à section essentiellement circulaire et ce faisceau laser, qui forme sur la couche photosensible un point lumineux on un petit spot lumineux, est dévié dynamiquement dans la deuxième direction par un système de déviation de lumière.

Dans le procédé conforme à l'invention, la création de la structure d'interférence dans la couche photosensible ne s'effectue pas d'une manière purement statique par exposition étendue de l'ensemble de la surface, mais d'une manière continue par éclairement en forme de pinceau et déplacement relatif entre le faisceau lumineux et la couche photosensible. La vitesse relative entre la couche photosensible et le faisceau, ainsi que l'intensité et la largeur on le diamètre du faisceau de rayons doivent alors être adaptés de manière à ce que l'énergie lumineuse nécessaire soit appliquée sur la couche photosensible. Grâce au mouvement relatif continu entre le faisceau de rayons et la couche photosensible, il est possible de confectionner de cette manière des hologrammes de longueur pratiquement illimitée.

Contrairement au procédé d'exposition statique connu, c'est seulement au niveau de la surface de réflexion allongée du faisceau étroit sur laquelle est produite l'onde objet interférant avec l'onde de référence, que le procédé conforme à l'invention nécessite que soit maintenue constante avec grande précision la distance séparant la couche photosensible de la surface de réflexion. Ceci s'avère incomparablement plus simple que le respect exact de cette distance sur l'ensemble de la surface de l'hologramme. Pour cette raison, le procédé conforme à l'invention permet de confectionner des miroirs holographiques bien plus uniformes que ceux obtenus avec le procédé connu.

Un autre avantage du nouveau procédé réside dans le fait que, au contraire de ce qui se passe dans le cas du procédé à exposition statique, des défauts optiques dans la couche photosensible ou dans le substrat, comme des inclusions ou des bulles, ainsi que des défauts superficiels, comme des griffes et de la poussière, ne produisent pas des images holographiques de ces défauts qui les amplifient encore davantage. De ce point de vue également, la qualité optique des miroirs holographiques confectionnés suivant l'invention est meilleure que celle des miroirs holographiques confectionnés selon le procédé connu.

La vitesse du déplacement relatif entre le faisceau de rayons lasers et la couche photosensible dans sa direction longitudinale est limitée par la puissance du laser produisant le faisceau lumineux. Pour augmenter davantage la vitesse du déplacement relatif, la couche photosensible peut être exposée simultanément à plusieurs faisceaux lasers provenant de lasers différents. Dans le cas d'une exposition à plusieurs lasers, il faut simplement garantir que les structures d'interférence produites par les divers lasers ne s'effacent pas mutuellement. Ceci est cependant le cas avec la plupart des lasers continus. Ainsi, un laser à ions argon présente une largeur de bande d'environ 6 GHz. De cette façon, les structures d'interférence de divers lasers espacés au maximum de plusieurs millimètres de l'interface réfléchissante, diffèrent de moins de 1/10 de l'interfrange.

Pour la production de l'onde objet qui forme, avec l'onde de référence, la structure d'interférence dans la couche photosensible, on peut utiliser d'une manière connue une surface réfléchissante disposée parallèlement à la couche photosensible. Etant donné que dans le procédé conforme à l'invention, l'exposition ne s'effectue que selon une ligne ou selon une bande, on peut utiliser un miroir comportant une surface courbée dans la direction de déplacement de la couche photosensible, par exemple un miroir comportant une surface de forme cylindrique. La surface du miroir est alors, de préférence, couplée optiquement par l'intermédiaire d'un liquide d'indice à la couche photosensible ou au film support de la couche photosensible.

Suivant un développement avantageux du procédé de l'invention, la distance entre la couche photosensible et la surface réfléchissante produisant l'onde objet est maintenue constante par le fait que l'interface entre la couche photosensible et l'air ou, le cas échéant, l'interface entre le film support et l'air, sert de surface de réflexion, c'est-à-dire que l'on se passe de la surface de miroir supplémentaire pour la production de l'onde objet. On obtient ainsi l'avantage supplémentaire décisif que tous les mouvements de translation relatifs entre la couche photosensible et la surface réfléchissante sont évités.

Pour, dans le cas de petits angles d'incidence, c'est-à-dire d'angles inférieurs à l'angle limite de la réflexion totale, accroître le pouvoir de réflexion au niveau de la surface libre, on peut amener cette interface, c'est-à-dire la surface libre de la couche photosensible ou du film support, en contact avec un liquide réfléchissant, comme par exemple du mercure. L'onde objet réfléchie se présente de cette manière au niveau de l'interface entre la couche photosensible et le mercure ou entre le film support et le mercure.

D'autres réalisations appropriées et développements avantageux du procédé conforme à l'invention ressortiront de la description suivante de divers exemples de réalisation de ce nouveau procédé, donnée en référence aux dessins annexés, dans lesquels :
- les figures 1a et 1b illustrent un montage pour l'exécution du procédé conforme à l'invention à l'aide d'un pinceau laser divergent qui convient pour des angles d'incidence relativement grands,
- les figures 2a et 2b illustrent un montage pour l'exécution du nouveau procédé à l'aide d'un pinceau laser divergent convenant pour des angles d'incidence plus petits,
- la figure 3 illustre un montage pour l'exécution du nouveau procédé avec une réflexion renforcée au niveau d'un liquide réfléchissant en contact avec la couche photosensible ou avec le film support et,
- la figure 4 illustre un montage pour l'exécution du procédé de l'invention à l'aide d'un faisceau laser parallèle essentiellement cylindrique.

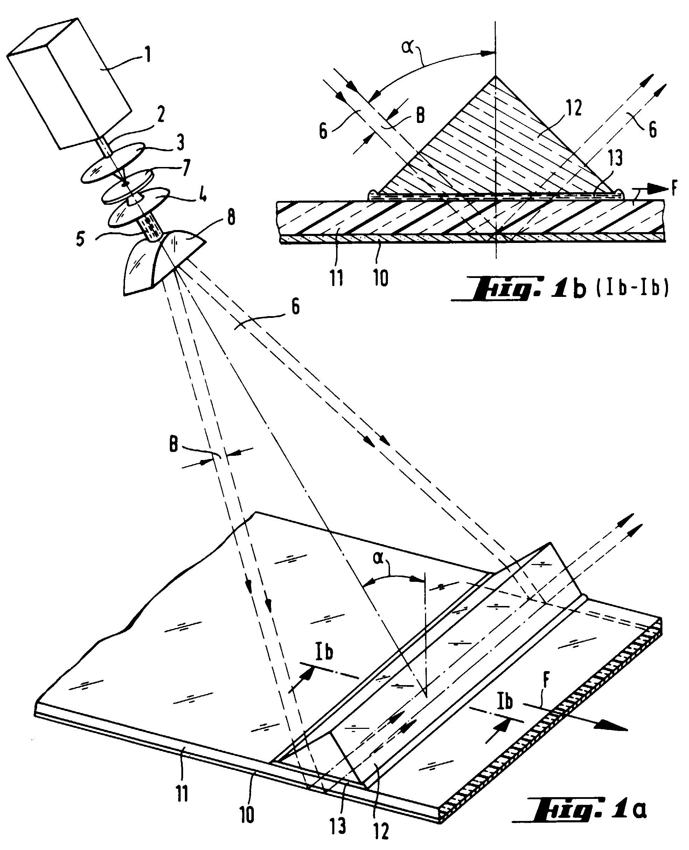

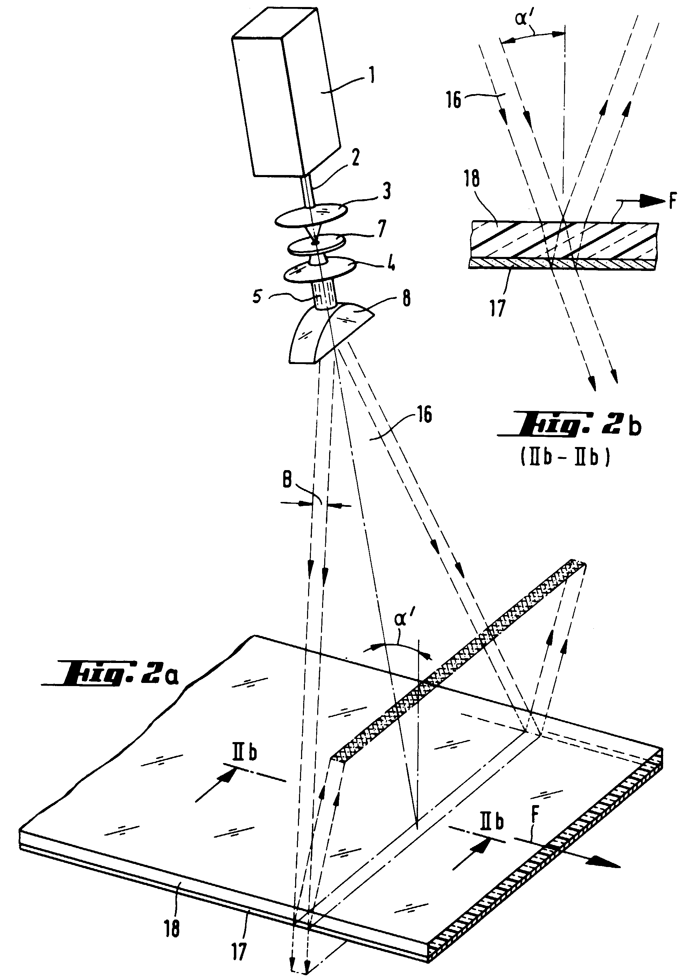

Les formes d'exécution du procédé de l'invention illustrées sur les figures 1 et 2 ont en commun qu'un pinceau laser de section appropriée est initialement produit. Un montage possible pour la production d'un tel pinceau laser est illustré, par sa structure fondamentale, dans les dessins. Il comprend un laser continu 1, duquel sort le faisceau laser 2. La section du faisceau laser 2 est augmentée de manière uniforme par passage à travers les deux lentilles 3 et 4 de distance focale adéquate. Entre les deux lentilles 3 et 4, dans le trajet des rayons, est installé un diaphragme 7. Le faisceau 5 sortant de la lentille 4 frappe une lentille cylindrique 8 qui élargit le faisceau lumineux dans une direction. La lentille cylindrique 8 est dans ce cas orientée de telle façon que la ligne d'intersection du pinceau lumineux 6 et de la couche photosensible 10 forme un angle droit ou, le cas échéant, un autre angle quelconque différent de zéro avec la direction de déplacement F de la couche photosensible.

L'angle α , sous lequel le pinceau lumineux entre dans la couche photosensible, détermine la structure d'interférence dans celle-ci, c'est-à-dire la distance entre les plans d'interférence et ainsi la caractéristique du miroir holographique. Par modification de l'angle d'incidence α , on peut adapter les propriétés de réflexion de l'hologramme à la longueur d'onde de la lumière qui doit être principalement réfléchie.

Il est également possible de confectionner des miroirs holographiques qui présentent sur la largeur de l'hologramme, un pouvoir de réflexion variant localement. Ceci peut être réalisé, par exemple, par le fait que l'on intercale sur le trajet des rayons du pinceau laser, un filtre d'absorption dont l'absorption de la lumière varie le long du filtre, de sorte qu'une bande de lumière à profil d'intensité souhaité soit obtenue sur la couche photosensible. Une autre possibilité pour confectionner un miroir holographique sans fin avec un profil d'intensité défini, consiste à associer côte à côte plusieurs pinceaux lumineux provenant de lasers à longueurs d'ondes différentes.

Dans le cas illustré sur les figures 1a et 1b, l'angle d'incidence α souhaité est supérieur à l'angle limite de la réflexion totale, de sorte que normalement, le pinceau de rayons 6 ne pénétrerait pas dans la couche photosensible 10. Pour rendre possible l'entrée du pinceau lumineux 6 dans le film support 11, le pinceau 6 est, par conséquent, introduit dans le film support 11 par l'intermédiaire d'un prisme 12, le prisme 12 étant couplé optiquement au film support 11 par l'intermédiaire d'un liquide d'indice 13 approprié.

La couche photosensible 10, par exemple de la gélatine bichromatée, se trouve sous la forme d'une couche mince, sur un film support transparent 11 approprié. L'incidence du pinceau laser 6 s'effectue à travers le film support 11. On obtient ainsi l'avantage particulier, comme déjà mentionné, que le rayon objet (pinceau lumineux réfléchi) interférant avec le rayon de référence (pinceau lumineux incident 6) est réfléchi directement sur l'interface libre de la couche photosensible ce qui évite les défauts qui dans le cas où la surface de réflexion est disposée à distance de la surface de la couche photosensible, se produiraient forcément lors du déplacement de la couche photosensible.

Le film support 11 pourvu de la couche photosensible 10 défile à une vitesse uniforme dans le sens de la flèche F, la vitesse de défilement est choisie de manière telle que, compte tenu de la largeur donnée B du pinceau de rayons 6 et de son intensité lumineuse donnée, la couche photosensible 10 soit correctement exposée.

L'incidence de la lumière dans la couche photosensible du côté du substrat offre en outre, également l'avantage d'un procédé relativement insensible aux variations de l'angle d'incidence α pendant l'exposition. La tolérance admissible pour l'angle d'incidence, c'est-à-dire sa variation tolérée, dépend, non seulement de la valeur de l'angle d'incidence lui-même, mais aussi de la distance séparant la couche photosensible de la surface réfléchissante produisant le faisceau objet. Les exigences de constance de l'angle d'incidence sont d'autant plus rigoureuses que cette distance est grande. Si l'angle d'incidence dans la couche photosensible est, par exemple, d'environ 45°, pour des variations d'angle pendant l'exposition allant jusqu'à 0,1°, on obtient un hologramme satisfaisant jusqu'à une distance de 20 microns de la surface réfléchissante, car dans ces circonstances, dans les systèmes d'interférence à enregistrer, les décalages qui se produisent sont de moins de 1/10 de l'interfrange.

Une tolérance angulaire de 0,1° est parfaitement réalisable et ne représente pas une exigence trop élevée pour la construction mécanique du dispositif. Par contre, la tolérance angulaire lors d'une incidence du côté de la couche photosensible, s'élèverait à une valeur nettemnt inférieure à 0,1° en raison de l'espacement plus important de la couche photosensible par rapport à la surface réfléchissante du film support, de sorte que dans ce cas, des exigences nettement plus rigoureuses seraient imposées à la précision d'un dispositif mécanique convenant à cet effet.

Le montage illustré sur les figures 2a et 2b convient pour les cas dans lesquels le pinceau laser 16 doit pénétrer sous un angle α relativement petit dans la couche photosensible 17. Etant donné que dans ce cas α' est inférieur à l'angle limite de la réflexion totale, le prisme est superflu et le pinceau de rayons lasers pénètre directement dans le film support 18.

En raison du petit angle d'incidence α',la réflexion au niveau de l'interface de la couche photosensible et de l'air est également assez faible, de sorte que la majeure partie du pinceau lumineux 16 ressort de la couche photosensible 17 et qu'une petite partie seulement du pinceau 16 est disponible, à titre de rayon objet réfléchi, pour la production d'interférences.

Dans le cas de milieux photosensibles déterminés, comme par exemple avec la gélatine bichromatée utilisée de préférence ici, un rapport très petit de l'intensité du rayon objet à celle du rayon de référence suffit cependant déjà pour produire des miroirs holographiques efficaces dont la réflexion dans la zone des rayons lumineux qui remplissent la condition de Bragg est supérieure à 99 %.

De faibles variations de l'angle d'incidence α' , telles qu'elles apparaissent lors du mouvement de transport du film support 18 pourvu de la couche photosensible 17, ne sont pas préjudiciables, mais sont mêmes avantageuses pour réduire ou exclure l'effet de réflexions au niveau de l'interface entre le film support et l'air. A cause de la tolérance angulaire plus faible, qui dans le cas de la réflexion sur l'interface entre le film support et l'air est inférieur de facteur d/D (d = épaisseur de la couche photosensible ; D = épaisseur du film support), ces réflexions ne contribuent plus à la formation de l'hologramme. En d'autres termes, cela signifie que ceci n'impose pas non plus d'exigence élevée pour ce qui est du guidage mécanique de la pellicule 18 portant la couche photosensible.

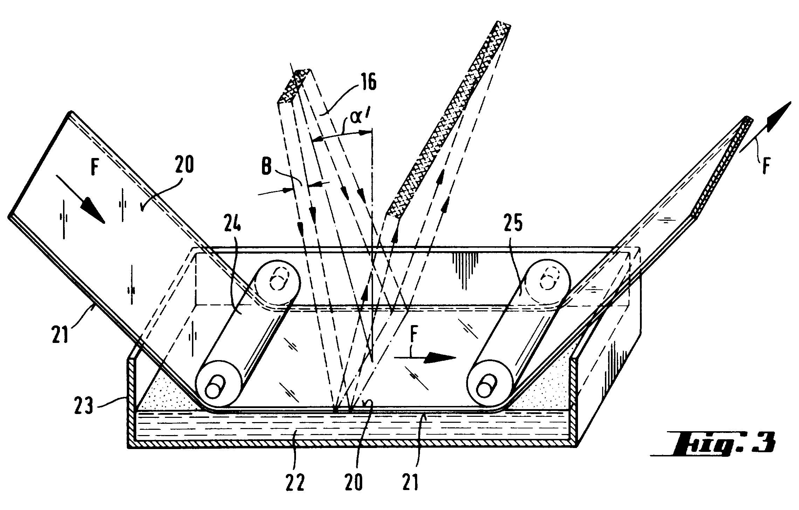

Le montage illustré sur la figure 3 diffère du montage illustré sur les figures 2a et 2b en ce sens que le degré de réflexion sur la face postérieure de la couche photosensible est augmenté par le fait que la face postérieure de la couche photosensible 21, est amenée en contact avec la surface fortement réfléchissante d'un liquide dans la zone d'incidence du pinceau laser. A titre de liquide, on peut utiliser à cet effet, par exemple, un bain de mercure 22. Le mercure se trouve dans un récipient adéquat 23. Dans le récipient 23 sont montés deux rouleaux 24, 25 dont la génératrice inférieure se trouve environ au niveau de la surface du bain de mercure. A l'aide de ces deux rouleaux 24, 25, la pellicule 20 est maintenue avec la couche photosensible 21 à un niveau tel qu'elle soit maintenue en contact avec la surface du bain. Etant donné que de cette manière, une réflexion de 100 % est obtenue au niveau de l'interface de la couche photosensible et du mercure, on peut ainsi produire, même pour de petits angles d'incidence α', des rapports de l'onde objet à l'onde de référence d'environ 1.

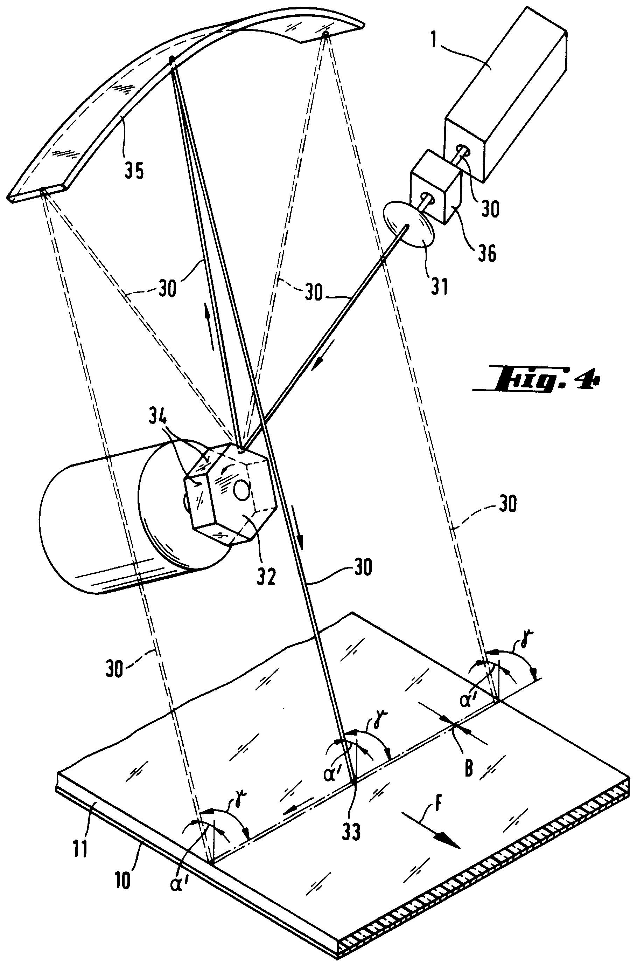

La figure 4 illustre à titre d'exemple, d'une manière schématique, un montage qui convient pour l'exécution du procédé au moyen d'un faisceau parallèle essentiellement cylindrique. Le faisceau 30 produit par le laser 1 frappe la surface réfléchissante d'un miroir tournant polygonal 32 après avoir traversé une optique de focalisation 31. L'optique de focalisation 31 sert à fixer la grandeur du spot lumineux 33 et ainsi la largeur B de la piste lumineuse sur la couche photosensible. L'axe de rotation du miroir polygonal 32 est disposé de telle façon que la surface du miroir 34 en question qui réfléchit le faisceau laser 30 soit située au foyer d'un miroir concave 35. Par la rotation du miroir polygonal 32, le faisceau laser 30 est réfléchi périodiquement sur le miroir concave 35 et de ce miroir, sur la pellicule 11 portant la couche photosensible 10. De cette manière le faisceau de rayons 30 est dévié à une fréquence souhaitée qui est accordée sur la vitesse de défilement de la pellicule 11 dans le sens de la flèche F, sur la largeur de la couche photosensible 10. Les composants optiques sont, dans ce cas, conformés de telle façon que la grandeur du spot lumineux 33 et les angles d'incidence α' et γ restent à peu près constants pendant l'opération de balayage.

Lorsque l'on veut produire un miroir holographique qui doit présenter différentes propriétés de réflexion dans le sens transversal et/ou dans le sens longitudinal de l'hologramme, on peut intercaler dans le trajet des rayons du faisceau laser 30 un modulateur électro-optique 36. Grâce à ce modulateur électro-optique 36, l'intensité lumineuse peut être modifiée dynamiquement pendant l'opération d'analyse d'un point à un autre sous la commande d'un ordinateur conformément à un programme souhaité.

Par rapport à la projection statique au moyen d'un faisceau laser plat, la projection dynamique au moyen d'un faisceau laser cylindrique offre l'avantage que pour chaque élément de surface du miroir holographique à exposer, on dispose à présent de la puissance totale du laser. Le temps d'exposition par élément de surface est de cette façon réduit de manière drastique (facteur 1000 et davantage), de sorte que les exigences de stabilité pour l'enregistrement de l'hologramme dans chaque élément de surface deviennent nettement moins critiques. Le temps d'exposition intégré sur une largeur d'hologramme reste évidemment égal au temps d'exposition qui est nécessaire lors de l'utilisation du pinceau de lumière statique, dans la mesure où la sensibilité à la lumière de la couche photosensible est indépendante de son intensité.

## Revendications

1. Procédé de réalisation d'un miroir holographique étendu obtenu en exposant une couche photosensible à des rayonnements laser qui interfèrent et à l'aide desquels on obtient, à l'intérieur même de la couche photosensible, parallèlement à sa surface, des plans d'égale différence de phase espacés d'une distance prédéterminée par la longueur d'onde de la lumière destinée à être réfléchie par l'hologramme dans lequel la couche photosensible est éclairée selon des lignes ou des bandes par au moins un faisceau laser sous une incidence donnée dans une première direction et dans lequel, dans une deuxième direction parallèlement à la surface de la couche photosensible, on crée un mouvement relatif entre la couche photosensible et le faisceau laser avec une vitesse telle qu'elle garantisse un éclairage suffisant de ladite couche, **caractérisé en ce que** le mouvement relatif entre la couche photosensible et le faisceau laser est un mouvement continu.

2. Procédé suivant la revendication 1, **caractérisé en ce qu'**à titre de faisceau laser, on utilise un pinceau laser statique divergent, à section essentiellement unidimensionnelle, qui forme sur la couche photosensible une bande lumineuse s'étendant dans la première direction.

3. Procédé suivant la revendication 1, **caractérisé en ce qu'**à titre de faisceau laser, on utilise un faisceau laser parallèle, à section essentiellement circulaire, et en ce que ce faisceau laser est dévié dynamiquement dans la première direction par un système de déviation de lumière.

4. Procédé suivant la revendication 2 ou 3, **caractérisé en ce que** l'exposition selon des lignes ou des bandes s'effectue dans une direction transversale à la direction du déplacement relatif.

5. Procédé suivant l'une ou plusieurs des revendications 1 à 4, **caractérisé en ce que**, pour produire le faisceau laser on utilise des dispositifs qui sont montés fixes, la couche photosensible et éventuellement un substrat qui la porte se déplaçant d'un mouvement continu.

6. Procédé suivant l'une ou plusieurs des revendications 1 à 5, **caractérisé en ce que** le faisceau objet qui produit la structure interférentielle est produit sur une surface réfléchissante qui est couplée optiquement par l'intermédiaire d'un liquide d'indice à la couche photosensible ou à un substrat qui la porte.

7. Procédé suivant l'une ou plusieurs des revendications 1 à 5, **caractérisé en ce que** l'on dispose la couche photosensible sur un substrat transparent, en particulier sur un film, et qu'on réalise l'incidence du faisceau laser sur la face du substrat opposée à la couche **et en ce que** la fraction du faisceau laser réfléchie par la surface limite libre de la couche photosensible sert de rayon objet réfléchi pour la formation de la structure d'interférence.

8. Procédé suivant l'une ou plusieurs des revendications 1 à 7, **caractérisé en ce que** l'incidence du faisceau laser dans un substrat portant la couche photosensible ou directement dans la couche photosensible elle-même est réalisée à l'aide d'un prisme oblong en contact avec le substrat ou avec la couche photosensible par l'intermédiaire d'un liquide d'indice.

9. Procédé suivant l'une ou plusieurs des revendications 1 à 5, **caractérisé en ce que** pour augmenter le degré de réflexion sur la surface libre de la couche photosensible, cette surface est amenée en contact avec la surface d'un liquide réfléchissant la lumière.

10. Procédé suivant la revendication 9, **caractérisé en ce qu'**à titre de liquide réfléchissant la lumière, on utilise du mercure.

11. Procédé suivant l'une ou plusieurs des revendications 3 à 10, **caractérisé en ce que** l'intensité du point lumineux destiné à produire un profil d'intensité défini dans la direction de déviation est modifiée sous la commande d'un ordinateur.

## Patentansprüche

1. Verfahren zur Herstellung eines flächigen Reflexionshologramms durch Belichten einer lichtempfindlichen Schicht mit interferierender Laserstralung, mit deren Hilfe im Innern der lichtempfindlichen Schicht parallel zu ihrer Oberfläche verlaufende Ebenen von gleichem Phasenunterschied in einem durch die Wellenlänge des durch das Hologramm zu reflektierenden Lichts vorbestimmten Abstand voneinander entfernt sind, indem die lichtempfindliche Schicht in einer ersten Richtung entlang von Linien oder Streifen mit wenigstens einem unter einem gegebenen Einstrahlungswinkel einfallenden Laserstrahlenbündel bestrahlt wird, und in einer zweiten Richtung parallel zur Oberfläche der lichtempfindlichen Schicht eine Relativbewegung zwischen der lichtempfindlichen Schicht und dem Laserstrahl mit einer Geschwindigkeit erzeugt wird, die eine ausreichende Belichtung dieser Schicht bewirkt, **dadurch gekennzeichnet**, daß die Relativbewegung zwischen der lichtempfindlichen Schicht und dem Laserstrahl eine kontinuierliche Bewegung ist.

2. Verfahren nach Anspruch 1, dadurch gekennzeichnet, daß als Laserstrahlung ein divergierendes statisches Laserstrahlenbündel mit im wesentlichen eindimensionalem Querschnitt verwendet wird, das auf der lichtempfindlichen Schicht einen sich in der ersten Richtung erstreckenden Lichtstreifen bildet.

3. Verfahren nach Anspruch 1, dadurch gekennzeichnet, daß als Laserstrahlung ein paralleles Laserstrahlenbündel mit im wesentlichen kreisförmigem Querschnitt verwendet wird, und dadurch, daß das Laserstrahlenbündel in der ersten Richtung durch ein Lichtablenksystem dynamisch abgelenkt wird.

4. Verfahren nach Anspruch 2 oder 3, dadurch gekennzeichnet, daß die Belichtung entlang der Linien oder Streifen in einer Richtung erfolgt, die quer zur Richtung der Relativbewegung verläuft.

5. Verfahren nach einem oder mehreren der Ansprüche 1 bis 4, dadurch gekennzeichnet, daß zur Erzeugung des Laserstrahlenbündels fest angeordnete Vorrichtungen verwendet werden, während sich die lichtempfindliche Schicht und eventuell ein diese tragendes Substrat in kontinuierlicher Bewegung befinden.

6. Verfahren nach einem oder mehreren der Ansprüche 1 bis 5, dadurch gekennzeichnet, daß das die interferentielle Struktur bildende Laserstrahlenbündel auf einer reflektierenden Oberfläche erzeugt wird, die unter Zwischenschaltung einer Immersionsflüssigkeit an die lichtempfindliche Schicht oder an ein diese tragendes Substrat optisch angekoppelt wird.

7. Verfahren nach einem oder mehreren der Ansprüche 1 bis 5, dadurch gekennzeichnet, daß die lichtempfindliche Schicht auf ein transparentes Substrat, insbesondere auf einen Film, aufgebracht und das Laserstrahlenbündel auf die der Schicht gegenüberliegende Seite des Substrats eingestrahlt wird, und daß der Anteil der an der freien Grenzfläche der lichtempfindlichen Schicht reflektierten Laserstrahlen als reflektierter Objektstrahl zur Bildung der Interferenzstruktur dient.

8. Verfahren nach einem oder mehreren der Ansprüche 1 bis 7, dadurch gekennzeichnet, daß die Einstrahlung des Laserstrahlenbündels in ein die lichtempfindliche Schicht tragendes Substrat oder unmittelbar in die lichtempfindliche Schicht selbst mit Hilfe eines länglichen Prismas erfolgt, das mit dem Substrat oder mit der lichtempfindlichen Schicht über eine Immersionsflüssigkeit in Kontakt steht.

9. Verfahren nach einem oder mehreren der Ansprüche 1 bis 5, dadurch gekennzeichnet, daß zur Erhöhung des Reflexionsgrades an der freien Oberfläche der lichtempfindlichen Schicht diese Oberfläche in Kontakt mit der Oberfläche einer das Licht reflektierenden Flüssigkeit gebracht wird.

10. Verfahren nach Anspruch 9, dadurch gekennzeichnet, daß als lichtreflektierende Flüssigkeit Quecksilber verwendet wird.

11. Verfahren nach einem oder mehreren der Ansprüche 3 bis 10, dadurch gekennzeichnet, daß die Intensität des zur Erzeugung eines definierten Intensitätsprofils bestimmten Lichtpunktes in der Ablenkungsrichtung rechnergesteuert modifiziert wird.

## Claims

1. Method for the production of a large holographic mirror, created by exposing a photosensitive film to interfering laser radiations, by means of which there are created, inside the photosensitive film itself and parallel to its surface, planes of equal phase difference spaced apart by a distance predetermined by the wavelengths of the light intended to be reflected by the hologram, wherein the photosensitive film is illuminated along lines or strips by at least one laser beam at a given angle of incidence in a first direction and wherein, in a second direction parallel to the surface of the photosensitive film, a relative movement is created between the photosensitive film and the laser beam at a speed such that it assures sufficient illumination of said film, characterized in that the relative movement between the photosensitive film and the laser beam is a continuous movement.

2. Method according to claim 1, characterized in that, as laser beam, a stationary diverging laser beam having an essentially unidimensional cross-section is used, which forms on the photosensitive film a luminous strip extending in the first direction.

3. Method according to claim 1, characterized in that, as laser beam, a parallel laser beam having an essentially circular section is used, and in that this laser beam is deviated dynamically in the first direction by a light deviation system.

4. Method according to claim 2 or 3, characterized in that the exposure along lines or strips takes place in a direction transverse to the relative displacement direction.

5. Method according to one or more of claims 1 to 4, characterized in that, for producing the laser beam, devices are used which are mounted fixed, the photosensitive film and, where applicable, a substrate carrying it moving with a continuous movement.

6. Method according to one or more of claims 1 to 5, characterized in that the object beam which creates the interferential structure is produced on a reflecting surface which is optically coupled by means of an index liquid to the photosensitive film or to a substrate that carries it.

7. Method according to one or more of claims 1 to 5, characterized in that the photosensitive film is disposed on a transparent substrate, in particular on a transparent film, and that the incidence of the laser beam is created on the face of the substrate remote from the photosensitive film and in that the fraction of the laser beam reflected by the free limiting surface of the photosensitive film serves as reflected object beam for the formation of the interference structure.

8. Method according to one or more of claims 1 to 7, characterized in that the incidence of the laser beam on a substrate carrying the photosensitive film or directly in the photosensitive film itself is created by means of an oblong prism in contact with the substrate or with the photosensitive film by means of an index liquid.

9. Method according to one or more of claims 1 to 5, characterized in that, for increasing the degree of reflection on the free surface of the photosensitive film, this surface is brought into contact with the surface of a light reflecting liquid.

10. Method according to claim 9, characterized in that, as light reflecting liquid, mercury is used.

11. Method according to one or more of claims 3 to 10, characterized in that the intensity of the light spot intended for producing a profile of defined intensity in the direction of deviation is modified under the control of a computer.
